# EUROPÄISCHE PATENTSCHRIFT

(11) **EP 0 877 458 B1**
(45) Veröffentlichungstag und Bekanntmachung des Hinweises auf die Patenterteilung: **23.11.2005**
(21) Anmeldenummer: 98106624.4
(22) Anmeldetag: 09.04.1998
(51) Int. Cl.: H02B 1/26, H03K 17/945

(54) **Verbindungs- und Montageanordnung**
Connection- and mounting device
Dispositif de connexion et de montage

(30) Priorität: 03.05.1997 DE 19718807
(43) Veröffentlichungstag der Anmeldung: 11.11.1998
(73) Patentinhaber: captron electronic gmbh, 81243 München (DE)
(72) Erfinder: Bellm, Reinhard, 82110 Germering (DE); Thiessen, Rainer, Dr., 80686 München (DE); Kuhn, Alain, 81243 München (DE)
(74) Vertreter: Strasser, Wolfgang

(56) Entgegenhaltungen:
- DE-A- 4 202 084
- DE-C- 4 208 087
- DE-U- 8 902 044
- US-A- 4 837 413

## Beschreibung

Die Erfindung betrifft eine Verbindungs- und Montageanordnung für eine flache Schaltereinheit.

Unter einer "flachen Schaltereinheit" sollen hier insbesondere Näherungsschalter verstanden werden, die in einem flachzylindrischen Gehäuse so angeordnet sind, daß die Annäherung eines Körpers, beispielsweise einer menschlichen Hand an die eine der Stirnseiten des flachen Zylinders zur Auslösung eines Schaltvorganges führt. Dabei kann die die Annäherung eines Körpers feststellende Elektronik in dem flachzylindrischen Schaltergehäuse untergebracht sein, so daß dieses Gehäuse dann nur noch Anschlüsse für die Stromversorgung und die Abgabe des Schaltsignales aufweisen muß.

Ein wichtiges Einsatzgebiet derartiger Schalter sind Verkehrsmittel wie z.B. Omnibusse und Straßenbahnen, bei denen die Fahrgäste durch Berühren einer entsprechend vorgegebenen und gekennzeichneten Fläche an der FahrzeugAußenseite die Tür öffnen bzw. an einer Oberfläche im Fahrzeuginneren ein Vorbereitungssignal erzeugen, das dazu führt, daß an der nächsten Haltestelle die betreffende Tür geöffnet wird, wenn der Fahrer des Fahrzeuges ein allgemeines Freigabesignal erzeugt.

Bei den genannten aber auch anderen Anwendungsfällen ist es häufig wünschenswert, derartige Schalter auf der von der Bedienungsperson abgewandten Seite einer Glasplatte so zu montieren, daß die näherungsempfindliche Schaltfläche mit der Glasplatte in Berührung steht, oder alternativ hierzu den flachen Schalter auf einer ihn tragenden im allgemeinen ebenen Fläche aus beliebigem Material so zu montieren, daß er nur geringfügig über diese Fläche vorsteht.

Damit in beiden Fällen ein und dasselbe Schaltergehäuse verwendet werden kann, ist es zweckmäßig, für die Hinterglas-Montage zusätzlich zum Schaltergehäuse einen geeigneten Montage-Ringflansch vorzusehen, während bei der Montage auf einer festen Oberfläche ein Abdeck-Ringflansch verwendet werden muß, der die näherungsempfindliche Fläche umgrenzt und einen kontinuierlichen Übergang zu der den Schalter tragenden Oberfläche schafft.

Aus der DE 42 08 087 C, ist eine Verbindungs-und Montageanordnung bekannt, mit deren Hilfe ein elektro-mechanischer Drucktaster, in einer seinem Durchmesser entsprechenden Bohrung einer Wand dadurch montiert wird, daß ein ihn im wesentlichen umgebender Ringflansch an seiner Außenumfangsfläche eine Nut aufweist, der im eingebauten Zustand eine entsprechende Nut in der Bohrungs-Innenwand des den Drucktaster tragenden Körpers gegenüberliegt. In die beiden Nuten ist ein O-Ring so eingefügt, daß der den Drucktaster tragende Ringflansch in der Bohrung des Körpers gehalten wird.

Aus der DE 89 02 044 U ist es bekannt, einen Näherungsschalter mit Hilfe einer ihn umgebenden Buchse in der durchgehenden Bohrung einer Wand zu montieren, wobei die Buchse in diese Bohrung eingeschraubt wird und an ihrer Innenumfangsfläche wenigstens eine Nut aufweist, der im zusammengebauten Zustand eine auf der Außenfläche des zylindrischen Näherungsschalters vorgesehene Umfangsnut gegenüberliegt. Die Verbindung zwischen der Montagebuchse und dem Näherungsschalter erfolgt mit Hilfe eines in diese beiden einander gegenüberliegenden Nuten eingefügten O-Rings.

In beiden Fällen ist es jedoch erforderlich, die den jeweiligen Schalter tragende Wand mit einerdurchgehenden Bohrung zu versehen, deren Innendurchmesser deutlich größer ist als der Außendurchmesser des Schalters, da die Bohrung jeweils auch noch den Ringflansch bzw. die Halterungsbuchse aufnehmen muß.

Demgegenüber liegt der Erfindung die Aufgabe zugrunde, eine Verbindungs- und Montageanordnung zu schaffen, bei der es nicht erforderlich ist, in der den Schalter tragenden Wand eine derart große Durchgangsöffnung auszubilden.

Zur Lösung dieser Aufgabe sieht die Erfindung die im Anspruch 1 zusammengefaßten Merkmale vor.

Durch die erfindungsgemäßen Maßnahmen wird eine außerordentlich kostengünstige Möglichkeit geschaffen, zunächst einen Montageflansch auf der einen Seite einer Glasscheibe beispielsweise durch Ankleben zu befestigen und dann das zylindrische Schaltergehäuse von hinten her in diesen Flansch einzuschieben.

Durch den vor dem Zusammenbau vorzugsweise in die umlaufende Ringnut des Schaltergehäuses eingesetzten und aus dieser Ringnut vorstehenden O-Ring wird eine durch elastische Verformung bewirkte Schnapp- und Rastverbindung zwischen dem Schaltergehäuse und dem Ringflansch hergestellt, die das Schaltergehäuse im Montageringflansch sicher haltert.

Es entsteht eine äußerst flache und auch den harten Einsatzbedingungen in Verkehrsmitteln gewachsene Anordnung, die besonders kostengünstig ist.

Ein weiterer Vorteil ist darin zu sehen, daß der Einbau und Austausch des Schalters bei der Hinterglasmontage ohne das Bohren von Löchern möglich ist. Das übliche Ausstanzen des gesamten Schalterdurchmessers ist bei dieser Montageart nicht erforderlich.

Weitere vorteilhafte Ausgestaltungen der erfindungsgemäßen Verbindungs- und Montageanordnung sind in den Unteransprüchen niedergelegt.

Die Erfindung wird im folgenden anhand von Ausführungsbeispielen unter Bezugnahme auf die Zeichnung beschrieben; in dieser zeigen:
- Fig. 1: eine auseinandergezogene Schnittdarstellung einer erfindungsgemäßen Verbindungs- und Montageanordnung für die Hinterglas-Montage eines Näherungsschalters,
- Fig. 1a: in vergrößertem Maßstab ein Detail aus der Darstellung in Fig. 1, wobei das flachzylindrische Schaltergehäuse und der Montageflansch ineinandergeschoben sind, ohne daß der Montageflansch an einer Glasscheibe befestigt ist,
- Fig. 1b: eine Schnittansicht der Anordnung aus Fig. 1 im zusammengebauten Zustand,
- Fig. 2: eine der Fig. 1 entsprechende Darstellung einer nicht zur Erfindung gehörenden Verbindungs- und Montageanordnung für eine auf einer ebenen Fläche erfolgenden Montage,
- Fig. 2a: eine Einzelheit der Anordnung aus Fig. 2 im zusammengebauten Zustand und
- Fig. 3: eine weitere Ausführungsform, bei der der eine Schalter einer Doppelschaltereinheit hinter Glas montiert und der andere Schalter von der Rückseite her zugänglich ist.

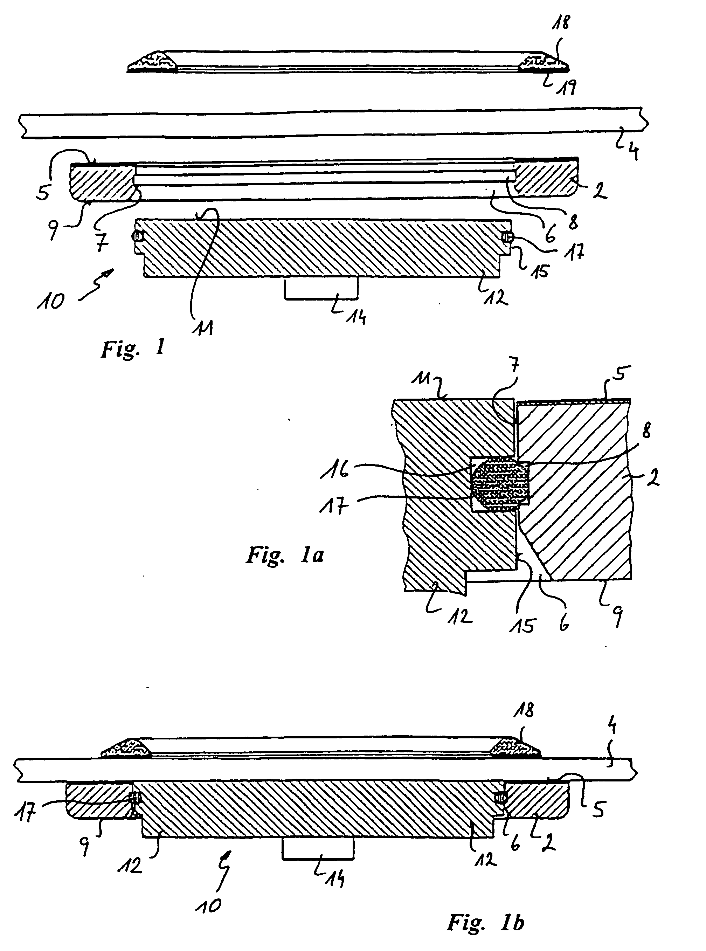

Bei der in den Fig. 1 bis 1b dargestellten Ausführungsform dient ein als Montageflansch 2 ausgebildeter Ring zur Befestigung der gesamten Anordnung an einer Glasscheibe 4. Zu diesem Zweck ist der Montageflansch 2 an seiner einen Stirnfläche mit einer Klebstoffschicht 5 versehen, mit deren Hilfe er dauerhaft an der Glasscheibe 4 befestigt werden kann, wie dies in Fig. 1b gezeigt ist.

Die sich durch den Montageflansch 2 hindurch erstreckende zentrale Öffnung 6 weist eine im wesentlichen zylindrische Innenfläche 7 auf, in der eine sich über den gesamten Umfang erstreckende Ringnut 8 ausgebildet ist.

An der Stirnseite 9, die der mit der Klebstoffschicht 5 beschichteten Stirnseite des Montageflansches 2 gegenüberliegt, erweitert sich die Öffnung 6 stumpfkegelig nach außen.

Die Schaltereinheit 10 besteht aus einem flachzylindrischen Schaltergehäuse 12, in dem ein in den Figuren nicht sichtbarer Näherungsschalter so untergebracht ist, daß seine für die Annäherung eines Körpers empfindliche Schalterfläche sich in der in den Fig. 1 bis 1b oben liegenden Stirnfläche 11 des Schaltergehäuses 12 befindet. Der Anschluß 14, mit dessen Hilfe der Näherungsschalter mit einer Schaltungselektronik verbunden werden kann, ist in den Fig. 1 und 1b nur schematisch dargestellt.

Das Schaltergehäuse 12 weist eine zylindrische Außenfläche 15 auf, deren Durchmesser nur geringfügig kleiner ist als der Durchmesser der Innenfläche 7 des Montageflansches 2. In der Außenfläche 15 ist eine sich über den gesamten Umfang erstreckende Ringnut 16 ausgebildet, die zur Aufnahme eines O-Rings 17 aus elastisch verformbarem Material dient.

Wie man insbesondere der Fig. 1a entnimmt, besitzt die Ringnut 16 in axialer Richtung eine Höhe, die geringfügig kleiner als die Dicke des O-Ringes 17 ist, so daß dieser unter leichter Kompression zwischen die in den Fig. 1 bis 1b obere bzw. untere Nut-Seitenwand eingeklemmt werden kann. Die Tiefe der Ringnut 16 senkrecht zur Außenfläche 15 ist so bemessen, daß der an der Bodenfläche der Ringnut 16 anliegende O-Ring zu etwa einem Viertel bis einem Drittel seiner Dicke über die Außenfläche 15 radial nach außen vorsteht.

Dieser vorstehende Teil des O-Rings greift, wie insbesondere in der Fig. 1a deutlich sichtbar, im zusammengebauten Zustand in die Ringnut 8 des Montageflansches 2 ein. Dabei sind die Abmessungen der Ringnut 8 an diesen vorstehenen Teil des O-Ringes so angepaßt, daß er sowohl mit dem Boden der Ringnut 8 als auch ihren beiden Seitenwänden in Eingriff steht.

Der axiale Abstand der axialen Mitte der Ringnut 8 von der mit Klebstoff 5 beschichteten Stirnfläche des Montageflansches 2 ist, wie man der Fig. 1a entnimmt, etwas kleiner als der axiale Abstand der axialen Mitte der Ringnut 16 von der Stirnfläche 11. Dies hat zur Folge, daß dann, wenn man das Schaltergehäuse 12 mit dem Montageflansch 2 durch Einschieben in axialer Richtung zusammenbaut, ohne daß der Montageflansch 2 an der Glasscheibe 4 angeklebt ist, die Stirnfläche 11 geringfügig über die Klebstoffschicht 5 in axialer Richtung vorsteht.

Allerdings wird in der Praxis der Montageflansch 2 vor dem Einschieben des Schaltergehäuses 12 an die Glasscheibe 4 angeklebt. Dadurch kann das Schaltergehäuse 12 nicht so weit in axialer Richtung vorgeschoben werden, wie dies Fig. 1a zeigt. Auf diese Weise bleibt der O-Ring 17 ständig etwas elastisch in der Weise verformt, daß er eine zur Glasscheibe 4 hin gerichtete Relativkraft zwischen dem Montageflansch 2 und dem Schaltergehäuse 12 erzeugt. Zusammen mit der Adhäsionskraft, die zwischen der entsprechend geschliffenen und polierten Stirnfläche 11 des Schaltergehäuses 12 und der Glasscheibe 4 im zusammengebauten Zustand entsteht, ergibt dies eine ausgezeichnete Halterung des Schaltergehäuses 12 am Montageflansch 2 und der Glasscheibe 4. Zumindest wird die Luftschicht zwischen der Glasscheibe 4 und der Stirnfläche 11 so dünn gehalten, daß keine Kondensatbildung und bei Verwendung eines kapazitiven Näherungsschalters keine Beeinträchtigung der Empfindlichkeit eintritt.

Auf der dem Montageflansch 2 und der Schaltereinheit 10 gegenüberliegenden Fläche der Glasscheibe 4 ist ein Abdeck- und Hand-Führungsring 18 vorgesehen, der mit Hilfe einer Kleberschicht 19 auf der Glasscheibe 4 dauerhaft befestigt werden kann und dessen Innendurchmesser so gewählt ist, daß er die bei Annäherung eines Körpers, beispielsweise einer menschlichen Hand einen Schaltvorgang auslösende, in der Stirnfläche 11 des Schaltergehäuses 12 angeordnete Schalterfläche umschließt und optisch und taktil deutlich erkennbar markiert.

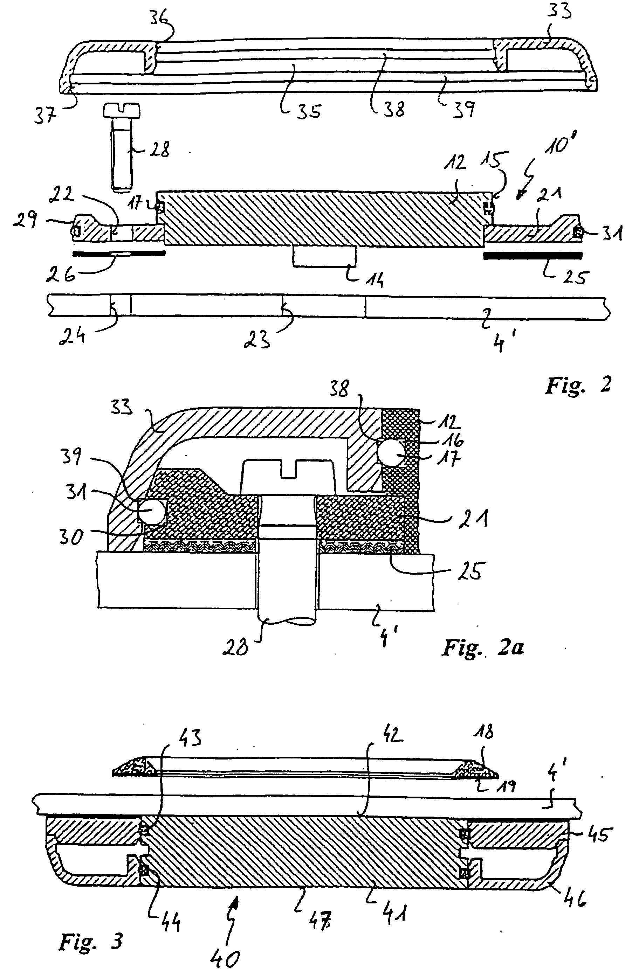

In den Fig. 2 und 2a ist eine nicht zur Erfindung gehörende Ausführungsform wiedergegeben, bei der die Schaltereinheit 10' neben dem flachzylindrischen Schaltergehäuse 12 einen kreisringförmigen Montageflansch 21 umfaßt, der mit dem Schaltergehäuse 12 auf herkömmliche Weise, beispielsweise durch Kleben verbunden ist. Alternativ hierzu kann der Montageflansch 21 mit dem Schaltergehäuse 12 auch einstückig ausgeführt oder in sonstiger Weise verbunden sein.

Der Montageflansch weist mehrere in axialer Richtung durchgehende Montagelöcher 22 auf, von denen im Schnitt der Fig. 2 und 2a jeweils nur eines wiedergegeben ist. Die Platte 4', auf deren in den Fig. 2 und 2a oberen Seite das Schaltergehäuse 12 montiert werden soll, weist hier eine durchgehende Öffnung 23 für den Anschluß 14 auf. Weiterhin sind in der Platte 4' mehrere durchgehende Montageöffnungen 24 vorgesehen, von denen in den Fig. 2 und 2a ebenfalls nur eine sichtbar ist. Zwischen der der Platte 4' zugewandten Stirnfläche des Montageflansches 21 und der Platte 4' ist ein Dichtring 25 vorgesehen, der den Montagelöchern 22 und Montageöffnungen 24 entsprechende durchgehende Öffnungen 26 besitzt. Im zusammengebauten Zustand fluchten dann, wenn der Anschluß 14 durch die Öffnung 23 hindurchragt, die Montagelöcher 22 mit den Öffnungen 26 und Montageöffnungen 24, so daß durch sie Befestigungsschrauben 28 hindurchgeführt werden können, die entweder in ein in die Platte 4' eingearbeitetes Gewinde (nicht dargestellt) eingreifen oder mit Hilfe einer (ebenfalls nicht dargestellten) Mutter auf der dem Schaltergehäuse 12 gegenüberliegenden Seite der Platte 4' verschraubt werden können.

Wie man den Fig. 2 und 2a entnimmt, besitzen hier sowohl das Schaltergehäuse 12 als auch der Montageflansch 21 zylindrische Außenflächen 15 bzw. 29, in die jeweils eine in Umfangsrichtung umlaufende Ringnut 16 bzw. 30 zur Aufnahme eines O-Ringes 17 bzw. 31 eingearbeitet ist. Die relativen Abmessungen der Ringnuten 16 und 30 in Bezug auf die O-Ringe 17, 31 sind die gleichen, wie dies oben unter Bezugnahme auf die Fig. 1 bis 1b beschrieben wurde.

Weiterhin ist bei diesem Ausführungsbeispiel ein ringförmiger Abdeckflansch 33 vorgesehen, dessen durchgehende Öffnung 35 zwei im wesentlichen zylindrische Innenwandabschnitte 36, 37 aufweist, deren unterschiedliche Durchmesser jeweils geringfügig kleiner als der Außendurchmesser der zylindrischen Außenfläche 15 des Schaltergehäuses 12 bzw. der zylindrischen Außenfläche 29 des Montageflansches 21 sind. In jeden dieser zylindrischen Innenwandabschnitte 36, 37 ist eine in Umfangsrichtung umlaufende Ringnut 38 bzw. 39 eingearbeitet, die, wie man insbesondere der Fig. 2a entnimmt, eine solche axiale Position besitzt, daß sie im zusammengebauten Zustand der Ringnut 16 des Schaltergehäuses 12 bzw. der Ringnut 30 des Montageflansches 21 gegenüberliegt und zur Aufnahme des aus diesen Ringnuten vorstehenden Teils des betreffenden O-Rings 17 bzw. 31 dient. Auch hier können die einander gegenüberliegenden Ringnuten axial so versetzt sein, daß die O-Ringe 17, 31 im zusammengebauten Zustand elastisch verformt bleiben und somit eine zur Platte 4' hin gerichtete Kraft auf den Abdeckflansch 33 ausüben.

Wie man den Fig. 2 und 2a entnimmt, sind auch hier die im wesentlichen zylindrischen Innenwandabschnitte 36, 37 zu der Seite hin stumpfkegelig erweitert, von der her die O-Ringe 17, 31 beim Zusammenbau eintreten, um das Aufschieben des Abdeckflansches 33 auf das Schaltergehäuse 12 und den Montageflansch 21 zu erleichtern.

Bei der in Fig. 3 wiedergegebenen Ausführungsform ist eine Doppel-Schaltereinheit 40 vorgesehen, die ein flachzylindrisches Schaltergehäuse 41 umfaßt, in dessen beiden Stirnflächen 42, 47 jeweils eine auf Annäherung reagierende Schaltfläche eines entsprechenden Schalters angeordnet ist. Somit kann diese Doppelschaltereinheit 40 sowohl von der in Fig. 3 oben liegenden Seite der Glasplatte 4 als auch von der in dieser Figur unten liegenden "Rückseite" her betätigt werden.

Die im wesentlichen zylindrische Außenfläche des Schaltergehäuses 41 weist hier zwei mit einem axialen Abstand angeordnete, im Umfangsrichtung verlaufende Ringnuten auf, in denen jeweils ein O-Ring 43, 44 untergebracht ist, von denen der O-Ring 43 zur Verbindung des Schaltergehäuses 41 in der gleichen Weise mit einem auf die Glasscheibe 4 aufgeklebten Montageflansch 45 dient, wie dies unter Bezugnahme auf die Fig. 1 bis 1b beschrieben wurde, und von denen der O-Ring 44 entsprechend dem Ausführungsbeispiel der Fig. 2 und 2a zur Halterung eines Abdeckflansches 46 vorgesehen ist. Die auch bei diesem Ausführungsbeispiel vorhandenen Anschlüsse, mit deren Hilfe die beiden im Schaltergehäuse 41 untergebrachten Näherungsschalter mit der zugehörigen Elektronik verbunden werden, sind seitlich herausgeführt und der Einfachheit halber in Fig. 3 nicht wiedergegeben.

Auch bei diesem Ausführungsbeispiel kann auf die der Doppelschaltereinheit 40 gegenüberliegende Fläche der Glasscheibe 4 ein Abdeck- und Hand-Führungsring 18 mit Hilfe einer Kleberschicht 19 aufgeklebt werden.

Auch bei dem in Fig. 3 gezeigten Ausführungsbeispiel kann im Berührungsbereich zwischen dem Montageflansch 45 und dem Abdeckflansch 46 ein gemäß der Erfindung zur Halterung dienender O-Ring in entsprechenden Nuten vorgesehen sein.

## Patentansprüche

1. Verbindungs- und Montageanordnung, die eine flache Schaltereinheit, in deren einer Flachseite die Betätigungsfläche eines Schalters liegt, und einen die Schaltereinheit umgebenden Ringflansch umfasst, wobei der Ringflansch (2; 45) als Montageflansch für eine einseitig auf eine Oberfläche eines Körpers (4, 4') aufgesetzte Montage ausgebildet ist und wenigstens eine im wesentlichen zylindrische Innenfläche (7) besitzt, in der eine in. Umfangsrichtung umlaufende Nut (8) ausgebildet ist, und die Schaltereinheit (10; 40) wenigstens eine im wesentlichen zylindrische Außenfläche (15) aufweist, deren Durchmesser geringfügig kleiner als der Durchmesser der Innenfläche (7) des Ringflansches (2; 45) ist und in der ebenfalls eine in Umfangsrichtung umlaufende Nut (16) ausgebildet und so positioniert ist, daß sie im zusammengebauten Zustand der Nut (8) des Ringflansches (2; 45) in etwa gegenüberliegt, und wobei ein in die eine der beiden Nuten vor dem Zusammenbau einsetzbarer O-Ring (17; 43, 44) aus elastischem Material eine solche Dicke besitzt, daß er unter elastischer Verformung so weit in die jeweilige Nut eindrückbar ist, daß die Schaltereinheit (10; 40) und der Ringflansch (2; 45) für einen Zusammenbau axial ineinander geschoben werden können, und der O-Ring (17; 43, 44) dann, wenn die beiden betreffenden Nuten einander in etwa gegenüberliegen, sich unter zumindest teilweiser elastischer Entspannung so weit in die andere der beiden Nuten hineinerstreckt, daß er die Schaltereinheit (10; 40) mit dem Ringflansch (2; 45) verbindet, und wobei schließlicht
der axiale Abstand der axialen Mitte der im Ringflansch (2) vorgesehenen Ringnut (8) von der im montierten Zustand an der Oberfläche zur Anlage kommenden Stirnfläche des Ringflansches (2) etwas kleiner als der axiale Abstand der axialen Mitte der Ringnut (16) der Schaltereinheit (10) von der im montierten Zustand an der Oberfläche zur Anlage kommenden Stirnfläche (11) der Schaltereinheit (10) ist, so daß im zusammengebauten aber nicht an der Oberfläche montierten Zustand die Stirnfläche (11) der Schaltereinheit (10) geringfügig über die im montierten Zustand an der Oberfläche zur Anlage kommende Stirnfläche des Ringflansches (2) vorsteht.

2. Verbindungs- und Montageanordnung nach Anspruch 1 **dadurch gekennzeichnet, daß** an der Schaltereinheit (40) eine weitere in Umfangsrichtung verlaufende Nut für einen O-Ring (44) vorgesehen ist, die zur Verbindung der Schaltereinheit (40) mit einem ringförmigen Abdeckflansch (46) dient.

## Claims

1. A connecting and assembly arrangement which includes a flat switch unit, in the one flat side of which is disposed the actuating surface of a switch, and an annular flange surrounding the switch unit, wherein the annular flange (2; 45) is in the form of an assembly flange for an assembly fitted at one side on to a surface of a body (4, 4') and has at least one substantially cylindrical inside surface (7) in which there is a groove (8) extending therearound in the peripheral direction, and the switch unit (10; 40) has at least one substantially cylindrical outside surface (15) whose diameter is slightly smaller than the diameter of the inside surface (7) of the annular flange (2; 45) and in which a groove (16) extending therearound in the peripheral direction is also provided and so positioned that in the condition of being fitted together it is approximately in opposite relationship to the groove (8) of the annular flange (2; 45), and wherein an O-ring (17; 43, 44) of elastic material which can be fitted into one of the two grooves before the arrangement is fitted together is of such a thickness that with elastic deformation it can be pressed into the respective groove to such an extent that the switch unit (10; 40) and the annular flange (2; 45) can be pushed axially one into the other for fitting together and when the two grooves in question are in approximately mutually opposite relationship the O-ring (17; 43, 44) extends with at least partial elastic stress relief into the other of the two grooves to such an extent that it connects the switch unit (10; 40) to the annular flange (2; 45), and wherein finally the axial spacing of the axial centre of the annular groove (8) in the annular flange (2) from the end face of the annular flange (2) which in the assembled condition comes to bear against the surface is somewhat smaller than the axial spacing of the axial centre of the annular groove (16) of the switch unit (10) from the end face (11) of the switch unit (10) which in the assembled condition comes to bear against the surface so that in the condition of being fitted together but not assembled to the surface the end face (11) of the switch unit (10) projects slightly beyond the end face of the annular flange (2) which in the assembled condition comes to bear against the surface.

2. A connecting and assembly arrangement according to claim 1 **characterised in that** provided on the switch unit (40) is a further peripherally extending groove for an O-ring (44) which serves for connecting the switch unit (40) to an annular cover flange (46).

## Revendications

1. Dispositif de connexion et de montage, comprenant une unité de commutation plate 9, au niveau d'une face plate de laquelle est située une surface d'actionnement d'un commutateur, et une bride annulaire entourant l'unité de commutation, la bride annulaire (2 ; 45) est réalisée sous la forme d'une bride de montage pour un montage rapporté d'un côté sur la surface supérieure d'un corps (4, 4') et comprend au moins une surface interne sensiblement cylindrique (7), dans laquelle est réalisée une rainure (8) qui s'étend de manière périphérique, et l'unité de commutation (10, 40) comprend au moins une surface externe sensiblement cylindrique (15), dont le diamètre est légèrement inférieur au diamètre de la surface interne (7) de la bride annulaire (2 ; 45) et dans laquelle est également réalisée une rainure (16) qui s'étend de manière périphérique et est positionnée de telle sorte qu'elle est située environ de manière opposée à la rainure 8 de la bride annulaire (2 ; 45) à l'état monté, un anneau torique (17 ; 43, 44) en matériau élastique insérable avant l'assemblage dans une des deux rainures présentant une épaisseur telle qu'il peut être pressé dans la rainure respective par déformation élastique aussi loin que l'unité de commutation (10, 40) et la bride annulaire (2 ; 45) peuvent être déplacées axialement l'un dans l'autre lors d'un assemblage, et l'anneau torique (17 ; 43, 44) s'étend alors, lorsque les deux rainures en question sont situées de manière environ opposée l'une à l'autre, aussi loin à l'intérieur de l'autre des deux rainures avec une contrainte élastique au moins partielle qui connecte l'unité de commutation (10 ; 40) à la bride annulaire (2 ; 45), et finalement la distance axiale entre le milieu axial de la rainure annulaire (8) prévue dans la bride annulaire (2) et la face frontale de la bride annulaire (2) venant en butée à l'état monté sur la surface supérieure est quelque peu inférieure à la distance axiale entre le milieu axial de la rainure annulaire (16) de l'unité de commutation (10) et la surface frontale (11) de l'unité de commutation (10) venant en butée à l'état monté sur la surface supérieure, de telle sorte qu'à l'état assemblé mais pas à l'état monté sur la surface supérieure, la surface frontale (11) de l'unité de commutation (10) fait légèrement saillie au-delà de la surface frontale de la bride annulaire (2) venant à l'état monté en butée sur la surface supérieure.

2. Dispositif de connexion et de montage selon la revendication 1, **caractérisé en ce que** l'unité de commutation (40) est pourvue d'une autre rainure périphérique pour un anneau torique (44), qui sert à la connexion de l'unité de commutation (40) avec une bride de recouvrement annulaire (46).
